# EUROPÄISCHE PATENTSCHRIFT

(11) **EP 2 928 750 B1**
(45) Veröffentlichungstag und Bekanntmachung des Hinweises auf die Patenterteilung: **30.11.2016**
(21) Anmeldenummer: 14705091.8
(22) Anmeldetag: 11.02.2014
(51) Int. Cl.: H05K 5/00, B61C 17/00, B61D 49/00

(54) **SCHIENENFAHRZEUG**
RAIL VEHICLE
VÉHICULE FERROVIAIRE

(30) Priorität: 12.02.2013 DE 102013202236
(43) Veröffentlichungstag der Anmeldung: 14.10.2015
(73) Patentinhaber: Siemens Aktiengesellschaft, 80333 München (DE)
(72) Erfinder: KAISER, Christian, 91301 Forchheim (DE)
(86) Internationale Anmeldenummer: PCT/EP2014/052587
(87) Internationale Veröffentlichungsnummer: WO 2014/124914

(56) Entgegenhaltungen:
- EP-A2- 1 095 836
- WO-A1-97/03873
- DE-C- 892 914

## Beschreibung

### Schienenfahrzeug

Die Erfindung betrifft ein Schienenfahrzeug mit einer elektrischen Ausrüstung, die elektrische Komponenten und zumindest eine Containereinheit aufweist, welche zur Aufnahme der elektrischen Komponenten vorgesehen ist.

Die elektrische Ausrüstung eines Schienenfahrzeugs weist herkömmlicherweise mehrere Funktionseinheiten auf, die in sogenannten Gerätecontainern oder auch elektrischen Schränken untergebracht sind.

Dokument WO-A-97/03873 offenbart einen Dachcontainer mit einem Grundrahmen, der mit elektrischen Geräte bestückbar ist. Der Erfindung liegt die Aufgabe zugrunde, ein Schienenfahrzeug mit einer Containereinheit bereitzustellen, durch welche ein geringer Aufwand bezüglich der Montage der elektrischen Ausrüstung sowie eine einfache und sichere Wartung der aufgenommenen Komponenten erreicht werden können.

Hierzu wird vorgeschlagen, dass die Containereinheit mehrere, räumlich voneinander abgegrenzte, aneinandergrenzende Spannungsbereiche aufweist, welchen jeweils eine unterschiedliche Spannung zugeordnet ist. Hierdurch können mehrere Spannungseinheiten der elektrischen Ausrüstung, die unter unterschiedlichen Spannungen betrieben werden, in einer vorteilhafterweise zusammenhängenden Containereinheit untergebracht werden. Durch eine Konzentration verschiedener Spannungseinheiten in einer gemeinsamen Containereinheit können eine einfache Montage und eine einfache Wartung der elektrischen Komponenten erreicht werden, wobei durch die Abgrenzung der Spannungsbereiche voneinander dennoch eine hohe Sicherheit bei der Wartung der aufgenommenen Komponenten erzielt werden kann. Unter einer "Spannungseinheit" soll in diesem Zusammenhang ein Zusammenschluss elektrischer Komponenten verstanden werden, die unter einer gemeinsamen Betriebsspannung betrieben werden. Die Spannungsbereiche sind zweckmäßigerweise für Spannungseinheiten vorgesehen, die jeweils unter einer unterschiedlichen Betriebsspannung betrieben werden. Hierbei ist den Spannungsbereichen vorteilhafterweise jeweils eine unterschiedliche Spannung zugeordnet, die der Betriebsspannung der jeweiligen aufgenommenen Spannungseinheit entspricht. Besonders vorteilhaft kann die Containereinheit einen ersten Spannungsbereich, welchem eine Hochspannung (z.B. 1.5 kV, 3kV, 15kV, 25kV) zugeordnet ist, und zumindest einen weiteren Spannungsbereich aufweisen, welchem eine Niederspannung (z.B. 110V, 380V) zugeordnet ist. Dadurch kann die Containereinheit sowohl elektrische Komponenten der Hochspannungsausrüstung des Schienenfahrzeugs als auch elektrische Komponenten einer Niederspannungsausrüstung, wie z.B. Funktionseinheiten für die Hilfsbetriebe, aufnehmen.

Durch die Konzentration verschiedener Spannungseinheiten in der gemeinsamen Containereinheit kann die Bereitstellung einer elektrischen Ausrüstung, welche Brandschutzanforderungen erfüllt, dadurch vereinfacht werden, dass die Anforderungen auf die Eigenschaften der Containereinheit verlagert werden. Erfüllt die Containereinheit bestimmte Anforderungen, kann die Erfüllung dann auch für die in der Containereinheit untergebrachten Komponenten gelten, sodass für die Zulassung des Schienenfahrzeugs erforderliche Nachweise für die einzelnen Komponenten entfallen können.

In Bezug auf Schienenfahrzeuge, die als Verband von mehreren Einheiten oder Wagen, insbesondere als mehrteiliger Triebzug ausgebildet sind, kann durch die Unterbringung verschiedener Komponenten in einer gemeinsamen Containereinheit die Ausgestaltung der elektrischen Ausrüstung in den verschiedenen Fahrzeugseinheiten bzw. Wagen vorteilhaft weitestgehend vereinheitlicht werden. Die Containereinheit ist zweckmäßigerweise als langgestreckte Baueinheit ausgebildet, wobei die Spannungsbereiche in Längsrichtung der Containereinheit betrachtet hintereinander angeordnet sind. Bezüglich einer Dimensionierung der Containereinheit nehmen die Spannungsbereiche Bauvolumina der Containereinheit in Anspruch, die im Wesentlichen gleich sind. Hierdurch kann eine vorteilhafte Einheitlichkeit in der Herstellung und in der Nutzung der Containereinheit erreicht werden. Insbesondere können die Spannungsbereiche einer Containereinheit mit n Spannungsbereichen und einem gesamten Bauvolumen V jeweils ein Bauvolumen von ca. V/n in Anspruch nehmen.

Durch die "räumliche Abgrenzung" der Spannungsbereiche voneinander kann eine eindeutige Zuordnung der Spannungsbereiche zu jeweils einem separaten Abschnitt der Containereinheit erreicht werden, sodass Überschneidungsabschnitte, in welchen Komponenten unterschiedlicher Spannungseinheiten angeordnet sind, weitestgehend vermieden werden können. In diesem Zusammenhang können die Spannungsbereiche auch als "Fächer" verstanden werden. Zur räumlichen Abgrenzung der Spannungsbereiche voneinander dient eine Trennung von zwei benachbarten Spannungsbereichen, die durch einen Luftabstand, bevorzugt jedoch durch eine physikalische Trennvorrichtung, beispielsweise durch eine Trennwand realisiert ist. Durch eine physikalische Trennvorrichtung kann insbesondere ein hoher Berührungsschutz erreicht werden, da sie bei einem Arbeiten an einer Spannungseinheit einen Zugang zu einer benachbarten Spannungseinheit und daher eine Berührung von deren Komponenten verhindert. Durch die räumliche Abgrenzung kann insbesondere eine elektrische Isolierung der Spannungsbereiche voneinander erreicht werden.

In einer bevorzugten Ausbildung der Erfindung ist die Containereinheit unterhalb eines Wagenkastens des Schienenfahrzeugs angeordnet. Dadurch kann die notwendige Entwärmung der elektrischen Komponenten vorteilhaft durch den Fahrtwind erreicht werden. Die Containereinheit ist insbesondere vollständig unterhalb des Bodenbereichs bzw. der Bodenplatte des Wagenkastens angeordnet, wodurch konstruktive Maßnahmen im Fahrgastraum, insbesondere eine Einschränkung der Sitzplatzanzahl entfallen können.

Außerdem wird vorgeschlagen, dass die Containereinheit eine zusammenhängende Trageeinrichtung aufweist, welcher die Spannungsbereiche gemeinsam trägt, wodurch eine konstruktiv einfache Befestigung der die Spannungsbereiche bildenden Bauelemente der Containereinheit erreicht werden kann.

Gemäß einer vorteilhaften Weiterbildung der Erfindung ist die Containereinheit als langgestreckte Baueinheit ausgebildet, deren Längsrichtung senkrecht zur Schienenfahrzeugslängsrichtung ausgerichtet ist. Hierdurch kann die Bauraumbeanspruchung durch die Containereinheit vorteilhaft optimiert werden. In dieser Ausgestaltung der Containereinheit kann sich diese vorteilhafterweise von einem Längsseitenbereich des Schienenfahrzeugs bis in den gegenüberliegenden Längsseitenbereich erstrecken.

In diesem Zusammenhang kann ein besonders einfacher, beidseitiger Zugang zur Containereinheit erreicht werden, wenn die Containereinheit zumindest zwei Wartungszugänge aufweist, die - in Längsrichtung der Containereinheit betrachtet - jeweils an einer unterschiedlichen Endseite der Containereinheit angeordnet sind. Die beiden Endseiten sind zweckmäßigerweise vertikal und senkrecht zur Längsrichtung der Containereinheit ausgerichtet und befinden sich vorzugweise jeweils in einem Längsseitenbereich des Schienenfahrzeugs.

Ein selektiver Zugang zu den Spannungsbereichen kann außerdem erreicht werden, wenn die Containereinheit für jeden Spannungsbereich jeweils zumindest einen separaten und unabhängigen Wartungszugang aufweist. Unter einem "unabhängigen Zugang" für einen Spannungsbereich soll ein Zugang verstanden werden, welcher von der Betätigung der Zugänge der anderen Spannungsbereiche unabhängig ist. Die Spannungsbereiche sind dabei vorteilhafterweise direkt und voneinander unabhängig zugänglich. Die Zugänglichkeit der Spannungsbereiche kann hierdurch vorteilhaft vereinheitlicht werden. Die Spannungsbereiche weisen konstruktionsbedingt grundsätzlich eine gleiche Zugänglichkeit auf, wobei eine Unterscheidung in der Zugänglichkeit durch spezielle, zusätzliche Vorrichtungen bereitgestellt werden kann. Insbesondere können für einen Spannungsbereich mit hohen Sicherheitsanforderungen - wie z.B. einen Hochspannungsbereich - spezielle Zugangs- bzw. Freigabemittel eingesetzt werden. In einer konstruktiv einfachen Ausgestaltung wird vorgeschlagen, dass die Containereinheit eine Bodenseite und für jeden Spannungsbereich jeweils zumindest einen separaten Wartungszugang aufweist, welcher an der Bodenseite angeordnet ist.

Der elektrische Anschluss der in der Containereinheit aufgenommenen Komponenten kann ferner dadurch vereinfacht werden, dass das Schienenfahrzeug Kabelschnittstellen aufweist, die an der Containereinheit angeordnet und jeweils einem unterschiedlichen Spannungsbereich zugeordnet sind. Durch die Benutzung von verschiedenen, separaten Kabelschnittstellen jeweils für einen unterschiedlichen Spannungsbereich kann eine einfache und übersichtliche Verkabelung erreicht werden.

Die Kabelschnittstellen können mit der Containereinheit einstückig hergestellt sein bzw. an der Containereinheit von dieser untrennbar befestigt sein. Jedoch kann eine hohe Flexibilität in der Anwendung der Containereinheit erreicht werden, wenn die Kabelschnittstellen an der Containereinheit lösbar von dieser montiert sind. Bei einem Schienenfahrzeug, welches als mehrteiliger Verband ausgebildet ist, können die Kabelschnittstellen an die Verdrahtung der jeweiligen Verbandseinheit bzw. des jeweiligen Wagens angepasst sein. Dadurch kann die Unterbringung elektrischer Komponenten bzw. deren Anordnung in den verschiedenen Verbandseinheiten vorteilhaft weitestgehend vereinheitlicht werden, da die Containereinheit in Bezug auf die Verkabelung der Komponenten an die jeweilige Verdrahtung flexibel anpassbar ist. Die Containereinheit kann zweckmäßigerweise derart gefertigt werden, dass sie für jeden Spannungsbereich jeweils zumindest einen Platzhalter für eine entsprechend der jeweiligen Spannungseinheit, an den Platzhalter bei einem Zusammenbauen des Schienenfahrzeugs anzubringende Kabelschnittstelle aufweist. Eine optimale und übersichtliche Kabelführung kann ferner erreicht werden, wenn das Schienenfahrzeug eine Kabelführungseinheit mit mehreren Kabelführungsstrecken aufweist, die jeweils einer unterschiedlichen Kabelschnittstelle zugeordnet sind. Insbesondere können bei einem Schienenfahrzeug, welches als mehrteiliger Verband ausgebildet ist, die Leitungswege vorteilhaft weitestgehend vereinheitlicht werden.

Es wird ein Ausführungsbeispiel der Erfindung anhand der Zeichnungen erläutert. Es zeigen:
- Figur 1:: einen elektrischen Triebzug mit Containereinheiten zur Aufnahme von elektrischen Komponenten in einer schematischen Seitenansicht,
- Figur 2:: eine perspektivische Ansicht einer der Containereinheiten von unten und
- Figur 3:: eine Detailansicht eines Spannungsbereichs der Containereinheit aus Figur 2.

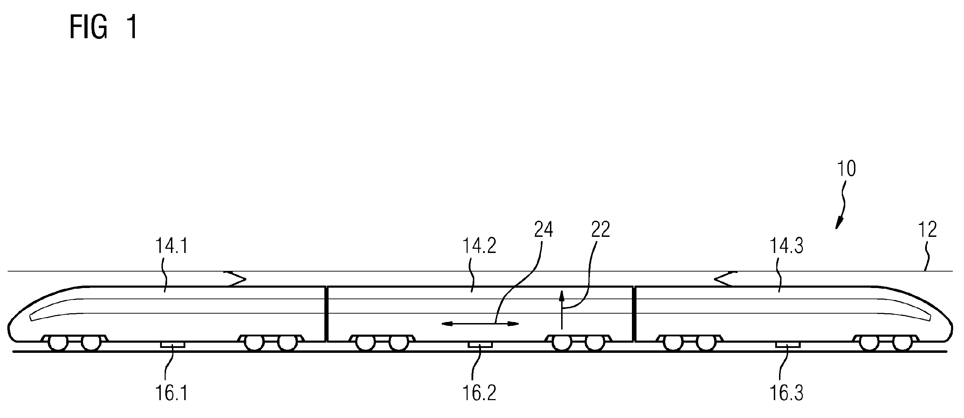

Figur 1 zeigt ein als Triebzug ausgebildetes Schienenfahrzeug 10 in einer schematisierten Seitenansicht. Das Schienenfahrzeug 10 bezieht eine elektrische Energie aus einer als Oberleitung ausgebildeten Bahnnetzversorgung 12, welche eine Hochspannung bereitstellt. Diese Hochspannung kann beispielsweise der Spannung 1.5 kV DC, 3kV DC, 15 kV AC oder 25 kV AC entsprechen. Das Schienenfahrzeug 10 ist ein Fahrzeugverband mit drei miteinander gekoppelten Wagen 14.1, 14.2 und 14.3, wobei unterschiedliche Anzahlen an Wagen für den Fahrzeugverband denkbar sind.

Durch die Bahnnetzversorgung 12 wird eine elektrische Ausrüstung des Schienenfahrzeugs 10 mit elektrischer Energie versorgt. Elektrische Komponenten, insbesondere Funktionseinheiten dieser elektrischen Ausrüstung, die unter der Hochspannung betrieben werden, bilden die Hochspannungsausrüstung des Schienenfahrzeugs 10. Diese Hochspannung wird bekannterweise in weitere Spannungen heruntertransformiert, unter welchen weitere Funktionseinheiten der elektrischen Ausrüstung betrieben werden. Beispielsweise sind Hilfsbetriebeumrichter Funktionseinheiten mit elektrischen Komponenten, die ausgehend von einer Niederspannung, z.B. 110 V DC, eine elektrische Leistung für Endverbraucher des Schienenfahrzeugs 10, wie z.B. Beleuchtungsanlagen, Steckdosen im Fahrgastraum usw. erzeugen. Diese Hilfsbetriebeumrichter stellen beispielhafte Funktionseinheiten der elektrischen Ausrüstung dar, die unter einer von der Hochspannung unterschiedlichen und niedrigeren Spannung betrieben werden.

Elektrische Komponenten der elektrischen Ausrüstung können - abhängig von deren Betriebsspannung - in Spannungseinheiten zusammengefasst werden, welchen jeweils eine unterschiedliche Spannung zugeordnet ist.

Bei dem betrachteten Schienenfahrzeug 10 sind elektrische Komponenten der elektrischen Ausrüstung in Containereinheiten 16 angeordnet, wobei für jeden Wagen 14.1, 14.2, 14.3 jeweils zumindest eine Containereinheit 16.1, 16.2 bzw. 16.3 vorgesehen ist.

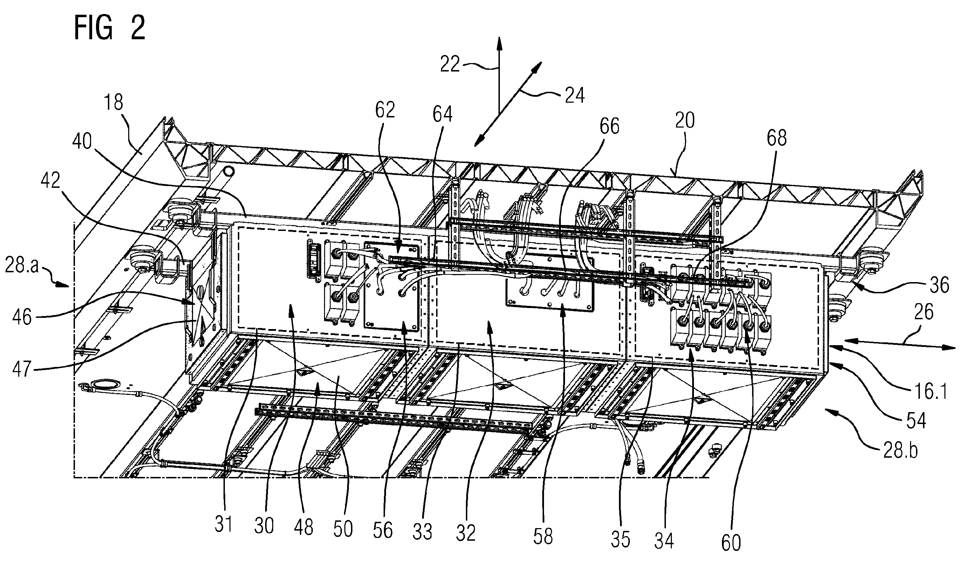

Figur 2 zeigt die Containereinheit 16.1 in einer perspektivischen Ansicht von unten. In der Figur ist ein Wagenkasten 18 des Wagens 14.1 teilweise dargestellt. Insbesondere ist die Bodenseite des Wagenkastens 18 zu sehen, welche den Bodenbereich 20 eines Fahrgastraums (nicht gezeigt) des Wagens 14.1 bildet. Bezüglich der Vertikalrichtung 22 ist der Fahrgastraum oberhalb des Bodenbereichs 20 angeordnet, wobei sich die Containereinheit 16.1 unterhalb des Wagenkastens 18 bzw. des Bodenbereichs 20 befindet. Die Containereinheit 16.1 ist demnach unterhalb des Fahrgastraums angeordnet und ist - in der fachmännischen Sprache ausgedrückt - in einer sogenannten "Unterfluranordnung" montiert. Die Längsrichtung 24 des Wagenkastens 18, die insbesondere den Fahrtrichtungen des Schienenfahrzeugs 10 entspricht, ist senkrecht zur Vertikalrichtung 22 ausgerichtet (siehe auch Figur 1).

Der Wagenkasten 18 weist eine in der Figur nicht gezeigte Oberseite, welche sich parallel zur Bodenseite erstreckt und den Dachbereich des Schienenfahrzeugs 10 bildet. Die Bodenseite und die Oberseite sind durch im Wesentlichen vertikal ausgerichtete, bezüglich der Längsrichtung 24 gegenüberliegende und sich parallel zu dieser erstreckende Längsseiten miteinander verbunden, welche die Längsseitenbereiche 28.a, 28.b des Schienenfahrzeugs 10 bilden.

Die Containereinheit 16.1 ist als langgestreckte Baueinheit ausgebildet, deren Längsrichtung 26 senkrecht zur Vertikalrichtung 22 und zur Längsrichtung 24 des Wagenkastens 18 ausgerichtet ist. Die Containereinheit 16.1 erstreckt sich von dem Längsseitenbereich 28.a des Schienenfahrzeugs 10 bis in den dem Längsseitenbereich 28.a bezüglich der Längsrichtung 24 gegenüberliegenden Längsseitenbereich 28.b. Hiermit spannt die Containereinheit 16.1 entlang der Richtung 26 den gesamten Bodenbereich 20 zwischen den Längsseitenbereichen 28.a und 28.b.

Bezüglich der oben erörterten Aufteilung der elektrischen Ausrüstung des Schienenfahrzeugs 10 in verschiedenen Spannungseinheiten, die jeweils einen Zusammenschluss elektrischer Komponenten darstellen, welche unter einer gleichen und bestimmten elektrischen Spannung betrieben werden, weist die Containereinheit 16.1 mehrere, räumlich voneinander abgegrenzte Spannungsbereiche 30, 32, 34 auf, in welchen jeweils eine unterschiedliche Spannungseinheit 31, 33, 35 aufgenommen ist. Die Spannungsbereiche 30, 32, 34 dienen hiermit als Einbauraum für jeweils eine Spannungseinheit 31, 33 bzw. 35. Die Spannungseinheiten 31, 33, 35 sind in der Figur stark schematisch gestrichelt dargestellt. Die Spannungsbereiche 30, 32, 34 grenzen paarweise aneinander an. Sie sind in Längsrichtung 26 der Containereinheit 16.1 betrachtet hintereinander angeordnet. Die Spannungsbereiche 30, 32, 34 nehmen außerdem jeweils ein Drittel des gesamten Bauvolumens der Containereinheit 16.1 in Anspruch.

Hiermit nehmen die Spannungsbereiche 30, 32, 34 jeweils einen Zusammenschluss elektrischer Komponenten auf, wobei die Zusammenschlüsse jeweils unter einer unterschiedlichen elektrischen Spannung betrieben werden. Im betrachteten Ausführungsbeispiel erfolgt eine Zuordnung der Niederspannung 380 V DC zum Spannungsbereich 30, der Hochspannung 3 kV DC zum Spannungsbereich 32 und der Niederspannung 110V DC zum Spannungsbereich 34.

Der Spannungsbereich 32, welcher insbesondere für die Spannungseinheit mit der höchsten Spannung vorgesehen ist - insbesondere für die Spannungseinheit 33, welche unter der Hochspannung des Schienenfahrzeugs 10 betrieben wird, ist in der Containereinheit 16.1 mittig angeordnet. Hierbei ist dieser Spannungsbereich 32 - senkrecht zur Vertikalrichtung 22 und zur Längsrichtung 24, d.h. in Längsrichtung 26 der Containereinheit 16.1 betrachtet - zwischen Spannungsbereichen angeordnet, welchen jeweils eine niedrigere Spannung zugeordnet ist.

Die Spannungsbereiche 30, 32, 34 werden von einer gemeinsamen, zusammenhängenden Trageeinrichtung 36 getragen. Diese weist zwei parallele, längliche Tragschienen 40, 42 auf, die sich in Längsrichtung 26 der Containereinheit 16.1 vom Längsseitenbereich 28.a bis in den Längsseitenbereich 28.b erstrecken.

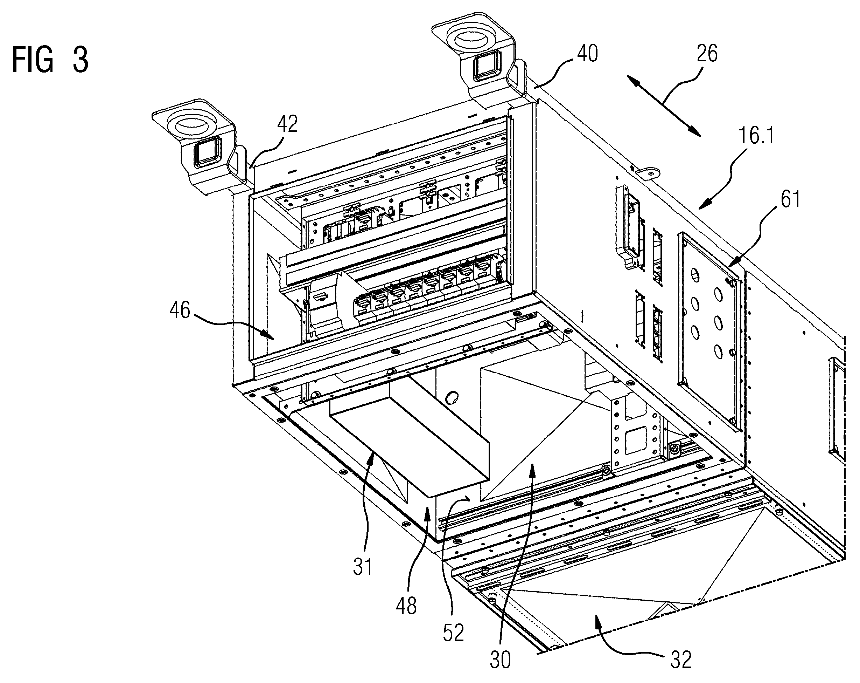

Figur 3 zeigt in einer detaillierten Ansicht den Spannungsbereich 30, in welchem die Spannungseinheit 31 mit ihren elektrischen Komponenten angeordnet ist. Um einen Zugang zu diesen elektrischen Komponenten zu ermöglichen weist die Containereinheit 16.1 einen ersten Wartungszugang 46 auf, welcher an einer senkrecht zur Längsrichtung 26 ausgerichteten Endseite der Containereinheit 16.1 im Längsseitenbereich 28.a angeordnet ist. Der Wartungszugang 46 ist hiermit im Längsseitenbereich 28.a des Schienenfahrzeugs 10 angeordnet und ermöglicht dadurch einen seitlichen Zugang, d.h. einen Zugang senkrecht zur Längsrichtung 24 des Schienenfahrzeugs 10 und zur Vertikalrichtung 22 zu den elektrischen Komponenten der Spannungseinheit 31. Der Wartungszugang 46 kann insbesondere durch Öffnung einer in Figur 2 dargestellten Wartungsklappe 47 freigemacht werden.

Um einen Zugang zu den elektrischen Komponenten der Spannungseinheit 31 von unten zu ermöglichen weist die Containereinheit 16.1 außerdem einen Wartungszugang 48 auf, welcher auf der Bodenseite der Containereinheit 16.1 in deren Spannungsbereich 30 angeordnet ist. Durch den Wartungszugang 48 kann ein Zugang zu diesem in Vertikalrichtung 22 nach oben erfolgen. Der Wartungszugang 48 kann mittels eines in Figur 2 dargestellten Montagedeckels 50 freigemacht werden.

Die Spannungsbereiche 30, 32, 34 sind mittels einer Trennvorrichtung 52, die insbesondere als Trennwand ausgebildet ist, voneinander getrennt, sodass bei einem Arbeiten an den Komponenten in einem Spannungsbereich der Wartungsarbeiter vor einer Berührung der elektrischen Komponenten einer benachbarten Spannungseinheit geschützt ist. In Figur 3 ist die den Spannungsbereich 30 vom Spannungsbereich 32 trennende Trennvorrichtung 52 dargestellt.

Die Beschreibung des Spannungsbereichs 30 findet auch für die Spannungsbereiche 32 und 34 Anwendung. Insbesondere ist für jeden weiteren Spannungsbereich 32, 34 jeweils ein separater Wartungszugang von unten vorgesehen, welcher entsprechend dem Wartungszugang 48 für den Spannungsbereich 30 ausgebildet ist. Ferner sind ebenfalls die Spannungsbereiche 32 und 34 mittels einer Trennvorrichtung 52 voneinander getrennt.

Um einen seitlichen Zugang zu den elektrischen Komponenten der Spannungseinheit 35 zu ermöglichen weist die Containereinheit 16.1 einen Wartungszugang 54 auf, welcher an einer senkrecht zur Längsrichtung 26 ausgerichteten Endseite der Containereinheit 16.1 im Längsseitenbereich 28.b angeordnet ist (siehe Figur 2). Der Wartungszugang 54, welcher dem Wartungszugang 46 gegenüber liegt, ist hiermit im Längsseitenbereich 28.b des Schienenfahrzeugs 10 angeordnet und ermöglicht dadurch einen seitlichen Zugang, d.h. einen Zugang senkrecht zur Längsrichtung 24 des Schienenfahrzeugs 10 und zur Vertikalrichtung 22 zu den elektrischen Komponenten der Spannungseinheit 35. Der Wartungszugang 54 kann mittels einer in den Figuren nicht sichtbaren Wartungsklappe freigemacht werden, die insbesondere identisch zur Wartungsklappe 47 ausgebildet ist.

Durch die Wartungszugänge 46 und 54 ist die Containereinheit 16.1 beidseitig, d.h. in den beiden, gegenüberliegenden Längsseitenbereichen 28.a, 28.b des Schienenfahrzeugs 10 zugänglich.

Der elektrische Anschluss der elektrischen Komponenten der Spannungseinheiten 31, 33, 35 wird anhand der Figuren 2 und 3 erläutert. Dieser erfolgt mittels Kabelschnittstellen 56, 58, 60, die jeweils einem unterschiedlichen Spannungsbereich 30, 32 bzw. 34 zugeordnet sind. Der elektrische Anschluss für die Spannungsbereiche 30, 32, 34 erfolgt demnach jeweils mittels einer separaten Kabelschnittstelle 56, 58 bzw. 60, die seitlich an der Containereinheit 16.1 angebracht ist. Die Kabelschnittstellen 56, 58, 60 weisen Kabelstecker, die an der Containereinheit 16.1 seitlich befestigt sind und/oder eine Kabeldurchführungsplatte auf, durch welche Kabel durchgeführt sind und die an der Containereinheit 16.1 seitlich angebracht ist.

Die Kabelschnittstellen 56, 58, 60 sind an der Containereinheit 16.1 lösbar befestigt. Insbesondere werden sie, entsprechend der Bestückung der verschiedenen Spannungsbereiche 30, 32, 34, beim Zusammenbau des Schienenfahrzeugs 10 an die Containereinheit 16.1 montiert. Hierzu wird die Containereinheit 16.1 mit Platzhaltern gefertigt, die jeweils zur Anbringung zumindest einer Kabelschnittstelle vorgesehen sind. Eine Platzhaltereinheit 61 mit mehreren Platzhaltern ist in Figur 3 zu sehen, in welcher die Containereinheit 16.1 in einem Montagezustand dargestellt ist, bei dem die Verkabelung der Spannungseinheiten 31, 33, 35 nicht vorhanden ist. Die Platzhaltereinheit 61 weist insbesondere eine Steckmöglichkeit für einen Kabelstecker und Aussparungen zur Aufnahme der Kabelstecker auf, die in Figur 2 dargestellt sind. Neben diese Aussparungen ist eine Kabeldurchführungsplatte angeordnet, die mit Bohrungen zur Durchführung von Kabeln versehen ist.

Die Kabelführung des Schienenfahrzeugs 10 ist im Bereich der Containereinheit 16.1 an den Aufbau dieser mit den verschiedenen Spannungsbereichen 30, 32, 34 angepasst. So weist eine Kabelführungseinheit 62 mehrere Kabelführungsstrecken 64, 66, 68 auf, die jeweils einer unterschiedlichen Kabelschnittstelle 56, 58 bzw. 60 zugeordnet sind bzw. die Kabel bis zur zugeordneten Kabelschnittstelle 56, 58 bzw. 60 führen.

Die Containereinheit 16.1 ist insbesondere aus Metall hergestellt und erfüllt die für die Fahrzeugzulassung gestellten Brandschutzanforderungen. Die Gehäuseteile, die die Containereinheit 16.1 bilden, sind insbesondere im Schutzgrad IP55 ausgeführt und weisen einen Feuerschutzwiderstand entsprechend E30 auf. Dadurch sind insbesondere die Brandschutzanforderungen nach DIN5510 für die in der Containereinheit 16.1 untergebrachte elektrische Ausrüstung auch erfüllt.

Die weiteren Containereinheiten 16.2 und 16.3 sind in ihrer Grundstruktur zumindest im Wesentlichen, insbesondere weitestgehend identisch zu der Containereinheit 16.1 ausgebildet. Sie können sich bezüglich ihrer Bestückung mit unterschiedlichen Spannungseinheiten voneinander unterscheiden, wobei die Verkabelung durch Verwendung der verschiedenen Kabelschnittstellen an die jeweilige Bestückung der Containereinheiten 16.2, 16.3 angepasst werden kann. Somit kann für die elektrische Ausrüstung in jedem Wagen 14.1, 14.2, 14.3 eine bezüglich der Grundstruktur einheitliche Containereinheit benutzt werden, die sich vorteilhaft bezüglich der Verkabelung bzw. der Kabelführung an die jeweiligen Bestückungen flexibel anpassen lässt.

## Patentansprüche

1. Schienenfahrzeug mit einer elektrischen Ausrüstung, die elektrische Komponenten und zumindest eine Containereinheit (16.1, 16.2, 16.3) aufweist, welche zur Aufnahme der elektrischen Komponenten vorgesehen ist,
**dadurch gekennzeichnet, dass**
die Containereinheit (16.1, 16.2, 16.3) mehrere, räumlich voneinander abgegrenzte, aneinandergrenzende Spannungsbereiche (30, 32, 34) aufweist, welchen jeweils eine unterschiedliche Spannung zugeordnet ist.

2. Schienenfahrzeug nach Anspruch 1,
**dadurch gekennzeichnet, dass**
die Containereinheit (16.1, 16.2, 16.3) zumindest eine Trennvorrichtung (52) aufweist, die zur Trennung von zwei benachbarten Spannungsbereichen (30, 32) dient.

3. Schienenfahrzeug nach Anspruch 1 oder 2,
**gekennzeichnet durch**
einen Wagenkasten (18), wobei die Containereinheit (16.1, 16.2, 16.3) unterhalb des Wagenkastens (18) angeordnet ist.

4. Schienenfahrzeug nach einem der vorhergehenden Ansprüche,
**dadurch gekennzeichnet, dass**
die Containereinheit (16.1, 16.2, 16.3) eine zusammenhängende Trageeinrichtung (36) aufweist, welcher die Spannungsbereiche (30, 32, 34) gemeinsam trägt.

5. Schienenfahrzeug nach einem der vorhergehenden Ansprüche,
**dadurch gekennzeichnet, dass**
die Containereinheit (16.1, 16.2, 16.3) als langgestreckte Baueinheit ausgebildet ist, deren Längsrichtung (26) senkrecht zur Schienenfahrzeugslängsrichtung (24) ausgerichtet ist.

6. Schienenfahrzeug nach Anspruch 5,
**dadurch gekennzeichnet, dass**
die Containereinheit (16.1, 16.2, 16.3) zumindest zwei Wartungszugänge (46, 54) aufweist, die - in Längsrichtung (26) der Containereinheit (16.1, 16.2, 16.3) betrachtet - jeweils an einer unterschiedlichen Endseite der Containereinheit (16.1, 16.2, 16.3) angeordnet sind.

7. Schienenfahrzeug nach einem der vorhergehenden Ansprüche,
**dadurch gekennzeichnet, dass**
die Containereinheit (16.1, 16.2, 16.3) eine Bodenseite und für jeden Spannungsbereich (30, 32, 34) jeweils zumindest einen separaten Wartungszugang (48) aufweist, welcher an der Bodenseite angeordnet ist.

8. Schienenfahrzeug nach einem der vorhergehenden Ansprüche,
**gekennzeichnet durch**
Kabelschnittstellen (56, 58, 60), die an der Containereinheit (16.1, 16.2, 16.3) angeordnet und jeweils einem unterschiedlichen Spannungsbereich (30, 32, 34) zugeordnet sind.

9. Schienenfahrzeug nach Anspruch 8,
**dadurch gekennzeichnet, dass**
die Kabelschnittstellen (56, 58, 60) an der Containereinheit (16.1, 16.2, 16.3) lösbar von dieser montiert sind.

10. Schienenfahrzeug nach Anspruch 8 oder 9,
**gekennzeichnet durch**
eine Kabelführungseinheit (62) mit mehreren Kabelführungsstrecken (64, 66, 68), die jeweils einer unterschiedlichen Kabelschnittstelle (56, 58, 60) zugeordnet sind.

## Claims

1. Rail vehicle comprising electric equipment which has electrical components and at least one container unit (16.1, 16.2, 16.3) which is provided to accommodate the electrical components,
**characterized in that**
the container unit (16.1, 16.2, 16.3) has a plurality of voltage regions (30, 32, 34) which are adjacent to each other and which are spatially separated from each other, a different voltage being associated with each region.

2. Rail vehicle according to Claim 1,
**characterized in that**
the container unit (16.1, 16.2, 16.3) has at least one separation device (52), which is used to separate two adjacent voltage regions (30, 32).

3. Rail vehicle according to Claim 1 or 2,
**characterized by**
a carriage body (18), wherein the container unit (16.1, 16.2, 16.3) is arranged below the carriage body (18).

4. Rail vehicle according to one of the preceding claims, **characterized in that**
the container unit (16.1, 16.2, 16.3) has a cohesive supporting arrangement (36), which jointly carries the voltage regions (30, 32, 34).

5. Rail vehicle according to one of the preceding claims, **characterized in that**
the container unit (16.1, 16.2, 16.3) is formed as an elongate structural unit, of which the longitudinal direction (26) is oriented perpendicularly to the longitudinal direction (24) of the rail vehicle.

6. Rail vehicle according to Claim 5,
**characterized in that**
the container unit (16.1, 16.2, 16.3) has at least two maintenance access points (46, 54), which, as considered in the longitudinal direction (26) of the container unit (16.1, 16.2, 16.3), are each arranged at a different end side of the container unit (16.1, 16.2, 16.3).

7. Rail vehicle according to one of the preceding claims, **characterized in that**
the container unit (16.1, 16.2, 16.3) has a base side and for each voltage region (30, 32, 34) at least one separate maintenance access point (48), which is arranged on the base side.

8. Rail vehicle according to one of the preceding claims, **characterized by**
cable interfaces (56, 58, 60), which are arranged on the container unit (16.1, 16.2, 16.3) and are each associated with a different voltage region (30, 32, 34).

9. Rail vehicle according to Claim 8,
**characterized in that**
the cable interfaces (56, 58, 60) are mounted on the container unit (16.1, 16.2, 16.3) so as to be detachable therefrom.

10. Rail vehicle according to Claim 8 or 9,
**characterized by**
a cable routing unit (62) comprising a plurality of cable routing paths (64, 66, 68), which are each associated with a different cable interface (56, 58, 60).

## Revendications

1. Véhicule ferroviaire ayant un équipement électrique qui a des composants électriques et au moins une unité (16.1, 16.2, 16.3) de container, qui est prévue pour loger les composants électriques,
**caractérisé en ce que**
l'unité (16.1, 16.2, 16.3) de container a plusieurs régions (30, 32, 34) de tension voisines les unes des autres, délimitées les unes par rapport aux autres dans l'espace et auxquelles est associée respectivement une tension différente.

2. Véhicule ferroviaire suivant la revendication 1,
**caractérisé en ce que**
l'unité (16.1, 16.2, 16.3) de container a au moins un dispositif (52) de séparation, qui sert à séparer deux régions (30, 32, 34) de tension voisines.

3. Véhicule ferroviaire suivant la revendication 1 ou 2,
**caractérisé par**
une caisse (18), l'unité (16.1, 16.2, 16.3) de container étant disposée sous la caisse (18).

4. Véhicule ferroviaire suivant l'une des revendications précédentes,
**caractérisé en ce que**
l'unité (16.1, 16.2, 16.3) de container a un dispositif (36) porteur, d'un seul tenant, qui porte conjointement les régions (30, 32, 34) de tension.

5. Véhicule ferroviaire suivant l'une des revendications précédentes,
**caractérisé en ce que**
l'unité (16.1, 16.2, 16.3) de container est constituée sous la forme d'une unité de construction s'étendant en longueur, dont la direction (26) longitudinale est perpendiculaire à la direction (24) longitudinale du véhicule ferroviaire.

6. Véhicule ferroviaire suivant la revendication 5,
**caractérisé en ce que**
l'unité (16.1, 16.2, 16.3) de container a au moins deux accès (46, 54) d'entretien, qui -considérés dans la direction (26) longitudinale de l'unité (16.1, 16.2, 16.3) de container- sont disposés respectivement d'un côté d'extrémité différent de l'unité (16.1, 16.2, 16.3) de container.

7. Véhicule ferroviaire suivant l'une des revendications précédentes,
**caractérisé en ce que**
l'unité (16.1, 16.2, 16.3) de container a un côté de fond et, pour chaque région (30, 32, 34) de tension respectivement, au moins un accès (48) d'entretien distinct qui est ménagé du côté de fond.

8. Véhicule ferroviaire suivant l'une des revendications précédentes,
**caractérisé par**
des interfaces (56, 58, 60) de câble qui sont ménagés sur l'unité (16.1, 16.2, 16.3) de container et qui sont associés respectivement à une région (30, 32, 34) de tension différent.

9. Véhicule ferroviaire suivant la revendication 8,
**caractérisé en ce que**
les interfaces (56, 58, 60) de câble sont montées sur l'unité (16.1, 16.2, 16.3) de container en pouvant en être retirées.

10. Véhicule ferroviaire suivant la revendication 8 ou 9,
**caractérisé par**
une unité (62) de guidage de câble ayant plusieurs tronçons (64, 66, 68) de guidage de câble qui sont associés, respectivement, à une interface (56, 58, 60) de câble différente.
